# EUROPÄISCHE PATENTANMELDUNG

(11) **EP 3 557 614 A1**
(43) Veröffentlichungstag der Anmeldung: **23.10.2019**
(21) Anmeldenummer: 18167698.2
(22) Anmeldetag: 17.04.2018
(51) Int. Cl.: H01L 25/07, H01L 25/11

(54) **LEISTUNGSMODUL MIT EINEM LEISTUNGSELEKTRONISCHEN BAUELEMENT AUF EINER SUBSTRATPLATTE UND LEISTUNGSELEKTRONISCHE SCHALTUNG MIT EINEM SOLCHEN LEISTUNGSMODUL**

(71) Anmelder: Siemens Aktiengesellschaft, 80333 München (DE)
(72) Erfinder: Strogies, Jörg, 14163 Berlin (DE); Müller, Bernd, 16259 Falkenberg (DE); Wilke, Klaus, 12527 Berlin (DE)

(57) **Zusammenfassung**

Die Erfindung betrifft ein Leistungsmodul (11) mit einem ersten leistungselektronischen Bauelement (31) und einem zweiten leistungselektronischen Bauelement (32). Außerdem betrifft die Erfindung auch eine leistungselektronische Schaltung, in der ein solches Leistungsmodul zum Einsatz kommt. Erfindungsgemäß ist vorgesehen, dass die elektronischen Bauelemente (31, 32) auf Substratplatten (12, 13) vormontiert werden können, so dass jeweils ein Chip-Keramik-Verbund entsteht. Diese jeweiligen Chip-Keramik-Verbünde können zur Herstellung des Leistungsmoduls auf einfache Weise gestapelt werden, wodurch ein modularer Aufbau und eine vorteilhaft platzsparende Anordnung möglich ist. Der große Anteil an Gleichteilen verbilligt überdies die Konzeption der modular aufgebauten leistungselektronischen Schaltung.

## Beschreibung

Die Erfindung betrifft ein Leistungsmodul mit einem leistungselektronischen ersten Bauelement, welches auf einer ersten Substratplatte montiert ist. Außerdem betrifft die Erfindung eine leistungselektronische Schaltung mit einer Vielzahl von Leistungsmodulen.

Leistungselektronische Schaltungen sind üblicherweise auf einen zugehörigen gegebenen Anwendungsfall anzupassen. Diese Anwendungsfälle unterscheiden sich individuell, wodurch bei der Auslegung der leistungselektronischen Schaltungen und bei deren Herstellung ein beträchtlicher Aufwand entsteht. Die individuellen Anwendungsfälle stehen insbesondere einer Automatisierbarkeit der Herstellung von Leistungsmodulen im Wege.

Die Aufgabe der Erfindung besteht darin, ein Leistungsmodul bzw. eine leistungselektronische Schaltung anzugeben, wobei sich mit dem Leistungsmodul leistungselektronische Schaltungen mit einem verringerten Aufwand bei der Konzeption bzw. bei der Herstellung erzeugen lassen sollen, insbesondere bei Einzelanfertigungen von Leistungsmodulen bzw. geringen Stückzahlen.

Die Lösung der angegebenen Aufgabe gelingt mit dem oben angegebenen Leistungsmodul erfindungsgemäß dadurch, dass ein leistungselektronisches zweites Bauelement, welches auf einer zweiten Substratplatte montiert ist, vorgesehen ist, wobei die erste Substratplatte, das erste Bauelement, die zweite Substratplatte und das zweite Bauelement einen Stapel bilden. Hierdurch ist vorteilhaft eine sehr platzsparende Anordnung der leistungselektronischen Bauelemente möglich. Außerdem können jeweils ein leistungselektronisches Bauelement und die zugehörige Substratplatte eine leistungselektronische Baueinheit bilden, welche vormontiert werden kann, so dass das Leistungsmodul durch Stapeln der genannten Grundeinheiten leicht auf unterschiedliche Anwendungen angepasst werden kann. Der Stapel kann dann weiterhin vormontiert werden, um leistungselektronische Schaltungen mit unterschiedlichen Anzahlen der gestapelten Module aufzubauen. Durch die Verwendung eines hohen Grades an Gleichteilen gelingt ohne größeren Aufwand vorteilhaft eine Skalierung der Leistungsmodule für unterschiedliche Anwendungsfälle.

Gemäß einer vorteilhaften Ausgestaltung der Erfindung ist vorgesehen, dass eine Oberseite des zweiten Bauelements elektrisch mit einer Unterseite der ersten Substratplatte verbunden ist. Die Begriffe "Oberseite" und "Unterseite" sind hierbei nicht von einer Einbaulage oder Positionierung des Leistungsmoduls im Betrieb abhängig. Vielmehr handelt es sich bei den Bauelementen um oberflächenmontierte Bauelemente, wobei diese Bauelemente gewöhnlich auf der Oberseite eines Substrats montiert sind und zwar mit der Unterseite des Bauelements. Somit ergibt sich unabhängig von der Einbaulage des Leistungsmoduls ein Bezugspunkt durch die Oberflächenmontage, der auch im Folgenden für die Definition von "Oberseite" und "Unterseite" dient.

Eine elektrische Verbindung der Oberseite des zweiten Bauelements mit einer Unterseite der ersten Substratplatte hat den Vorteil, dass das verwendete Bauelement sowohl mit der ersten Substratplate über seine Unterseite als auch mit der zweiten Substratplatte über seine Oberseite elektrische kommunizieren kann. Mit anderen Worten kann ein Bauelement verwendet werden, welches elektrische Kontaktflächen sowohl an seiner Oberseite als auch an seiner Unterseite aufweist. Hierdurch können insbesondere leistungselektronische Bauelemente mit vorteilhaft großflächigen Kontaktflächen kontaktiert werden, was die Leitung höherer Ströme zulässt und außerdem eine Wärmeableitung von Verlustwärme verbessert.

Gemäß einer anderen Ausgestaltung der Erfindung ist vorgesehen, dass das zweite Bauelement mit dem ersten Bauelement über einen elektrischen Verbindungspfad kontaktiert ist. Durch Vorsehen eines solchen elektrischen Verbindungspfades ist es vorteilhaft möglich, dass das erste Bauelement und das zweite Bauelement miteinander kommunizieren. Dies ermöglicht zusätzliche Anwendungen bei der Konzeptionierung der durch das Leistungsmodul realisierten elektrischen Schaltung, da eine elektrische Verschaltung der Bauelemente auf direktem Wege möglich ist.

Vorteilhaft kann der elektrische Verbindungspfad zwischen dem ersten Bauelement und dem zweiten Bauelement als Durchkontaktierung, insbesondere als Via, ausgebildet sein. Hierdurch ist vorteilhaft eine besonders direkte Kontaktierung möglich, wobei die Bauelemente diesseits und jenseits des ersten Schaltungsträgers also auf der Oberseite und der Unterseite der Substratplatte montiert sind. Die Durchkontaktierung führt dann zu einer elektrischen Verbindung zwischen den Bauelementen auf dem kürzest möglich Weg. Hierdurch können verlustarm höhere Ströme zwischen den Bauelementen fließen, wodurch eine effizient arbeitende leistungselektronische Schaltung aufgebaut werden kann.

Gemäß einer besondere Ausgestaltung der Erfindung ist vorgesehen, dass der elektrische Verbindungspfad als Halbbrücke ausgeführt ist, die einen Phasenkontakt zur Verfügung stellt. Hierdurch lässt sich beispielsweise eine leistungselektronische Schaltung realisieren (unter Verwendung gleichzeitig mehrerer anderer Leistungsmodule), bei der ein Gleichstrom in einen einphasigen oder mehrphasigen Wechselstrom umgewandelt wird. Die Phasenkontakte stellen dabei eine Anschlussmöglichkeit zur Verfügung, damit der Wechselstrom von dem Leistungsmodul oder einer mit den Leistungsmodulen realisierten elektrischen Schaltung abgegeben werden kann. Hierdurch ist es möglich, Leistungselektronische Schaltungen mit einer hohen Leistungsdichte pro Volumeneinheit herzustellen.

Gemäß einer anderen Ausgestaltung der Erfindung ist vorgesehen, dass zwischen der ersten Substratplatte und der zweiten Substratplatte mindestens ein Distanzstück angeordnet ist, das die erste Substratplatte und die zweite Substratplatte miteinander verbindet. Hierdurch ist es möglich, das Leistungsmodul zusätzlich mechanisch zu stabilisieren. Außerdem können die Distanzstücke auch als Abstandhalter dienen, um eine definierte elektrische Kontaktierung der elektronischen Bauelemente zu verwirklichen. Vorteilhaft können Distanzstücke außerdem mit demselben technischen Effekt auch zwischen der ersten Substratplatte und einer ersten Basisplatte angeordnet werden, wobei auch das erste Bauelement auf einer Oberseite mit der ersten Basisplatte verbunden ist. Die erste Basisplatte kann dabei vorteilhaft zusätzlich als Schaltungsträger dienen.

Gemäß einer Weiterbildung der Distanzstücke kann außerdem vorgesehen werden, dass diese elektrisch leitend ausgeführt sind. Hiermit wird es vorteilhaft möglich, dass das mindestens eine Distanzstück Leiterbahnen auf der ersten Substratplatte und der ersten Basisplatte miteinander elektrisch leitend verbindet. Genauso können die erste Substratplatte und die zweite Substratplatte mit den Distanzstücken elektrisch leitend verbunden werden, wobei auch hier auf den Substratplatten befindliche Leiterbahnen miteinander verbunden werden können. Elektrisch leitende Distanzstücke ermöglichen hierdurch eine komplexere Verschaltung der Bauelemente untereinander, wodurch der Gestaltungsspielraum für die Realisierung leistungselektronischer Schaltungen vorteilhaft erhöht wird. Die erfindungsgemäßen Leistungsmodule können dadurch auf engstem Raum konzipiert werden und die unterschiedlichsten elektrischen Aufgaben erfüllen.

Eine besondere Ausgestaltung der Erfindung sieht vor, dass die erste Basisplatte und/oder die zweite Basisplatte eine Kühlstruktur aufweist bzw. aufweisen. Hierdurch ist es möglich, die bei leistungselektronischen Schaltungen anfallende Wärme während des Betriebs zuverlässig und schnell abzuführen. Durch die hohe Kompaktheit des Leistungsmoduls ist es vorteilhaft, die Kühlstrukturen direkt an die Basisplatten anzuschließen, wodurch kurze Übertragungswege für die abzuführende Wärme entstehen. Die Kühlstruktur kann beispielsweise aus einem Rippenkühler bestehen, welcher mit der entsprechenden Basisplatte verbunden ist oder mit dieser ein gemeinsames Bauteil bildet (einstückige Herstellung).

Die erfindungsgemäße Ausprägung des Leistungsmoduls hat den Vorteil, dass sich dieses Leistungsmodul mit Leistungsmodulen derselben Bauart zu leistungselektronischen Schaltungen kombinieren lässt, deren Funktion sich mit geringem Aufwand an unterschiedliche Anwendungsfälle anpassen lässt. Insbesondere kann durch Parallelschalten mehrerer Leistungsmodule erreicht werden, dass sich die durch die Leistungsmodule erzeugte leistungselektronische Schaltung an verschiedene geforderte Leistungsbereiche anpassen lässt.

Demgemäß wird die oben angegebene Aufgabe auch durch eine leistungselektronische Schaltung gelöst, in der die beschriebenen Leistungsmodule verwendet werden, wobei mehrere Leistungsmodule jeweils durch Zusammenschluss elektrisch verbunden sind. Die so erzeugte leistungselektronische Schaltung lässt sich aufgrund des modularen Aufbaus mit einer Vielzahl von Gleichteilen erzeugen, was den Fertigungsaufwand vorteilhaft minimiert. Zusätzlich ergibt sich der Vorteil, dass auch eine Demontage der leistungselektronischen Schaltung mit einfachen Mitteln durchgeführt werden kann. Daher können beispielsweise defekte Leistungsmodule mit geringem Aufwand ausgetauscht werden.

Eine Ausgestaltung der bereits erwähnten leistungselektronischen Schaltung sieht vor, dass die Leistungsmodule je zwei als erstes Schaltelement und als zweites Schaltelement ausgebildete leistungselektronische Bauelemente aufweisen. Mit anderen Worten ist das eine elektronische Bauelement als erstes Schaltelement und das zweite elektronische Bauelement als zweites Schaltelement ausgebildet. Das erste Schaltelement und das zweite Schaltelement sind zu einem gemeinsamen Leistungsanschluss zusammengeschlossen, der insbesondere einen Phasenkontakt für eine Phase eines elektrischen Drehstroms ausbilden kann. Ein solcher gemeinsamer Leistungsanschluss wird auch als Halbbrücke bezeichnet. Das erste Schaltelement weist außerdem einen als Pluspol ausgeführten ersten Leistungsanschluss und das zweite Schaltelement einen als Minuspol ausgeführten zweiten Leistungsanschluss auf. Damit ist es möglich, den Leistungsanschluss durch die Schaltelemente abwechselnd auf den Minuspol und den Pluspol zu schalten, wodurch sich ein Wechselstrom erzeugen lässt. Die leistungselektronische Schaltung lässt sich damit vorteilhaft als modular aufgebauter Frequenzumrichter betreiben.

Gemäß einer Ausgestaltung der leistungselektronischen Schaltung kann vorgesehen werden, dass die Leistungsmodule in drei Gruppen mit jeweils gleich vielen Leistungsmodulen unterteilt sind, wobei in jeder der drei Gruppen die gemeinsamen Leistungsanschlüsse elektrisch miteinander verbunden sind und drei gemeinsame Leistungsanschlüsse mit je einem gemeinsamen Phasenkontakt ausbilden. Mit dieser Schaltung lässt sich vorteilhaft daher ein Drei-Phasen-Drehstrom erzeugen, wobei die Zusammenschaltung der Leistungsmodule zu Gruppen auch das Schalten höherer Ströme zulässt. Dabei werden so viele Leistungsmodule parallel geschaltet, dass der erforderliche Strom geschaltet werden kann. Damit die Leistungsmodule auch mit einer Gleichspannung versorgt werden können, müssen die ersten Leistungsanschlüsse aller Schaltelemente elektrisch miteinander verbunden werden und einen gemeinsamen Minuspol bilden, während die zweiten Leistungsanschlüsse aller Schaltelemente ebenfalls elektrisch miteinander verbunden werden, um einen gemeinsamen Pluspol zu bilden.

Vorteilhaft kann auch vorgesehen werden, dass die elektrische Verbindung der gemeinsamen Leistungsanschlüsse jeweils durch eine erste elektrische Verbindung und eine zweite elektrische Verbindung ausgebildet ist. Diese Konfiguration lässt sich einfach montieren, indem die Leistungsmodule in Reihen hintereinander angeordnet werden, wodurch sich die elektrische Verbindung automatisch ausbildet.

Die leistungselektronischen Bauelemente sind vorzugsweise als Nacktchip ausgeführt. Dieser lässt sich direkt mit der Substratplatte kontaktieren, beispielsweise durch eine Sinterverbindung, die auch einen elektrischen Kontakt gewährleistet. Die Substratplatte kann vorzugsweise aus einer Keramik hergestellt sein. Diese leitet den elektrischen Strom nicht, so dass gleichzeitig eine elektrische Isolation gewährleistet ist. Daher kann eine elektronische Schaltung durch Strukturieren einer elektrisch leitenden Beschichtung auf der Substratplatte realisiert werden. Hierdurch werden beispielsweise Kontaktflächen zur Kontaktierung der leistungselektronischen Bauelemente zur Verfügung gestellt.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Es zeigen:
- Figur 1: ein Ausführungsbeispiel des erfindungsgemäßen Leis-tungsmoduls als Seitenansicht,
- Figur 2: eine leistungselektronische Schaltung mit einer Vielzahl von Leistungsmodulen, die gemäß Figur 1 oder ähnlich aufgebaut sein können, als vereinfachtes Blockschaltbild,
- Figur 3: schematisch einen Schaltplan für eine Kontaktierung von Leistungsmodulen gemäß Figur 1 in einer leistungselektronischen Schaltung gemäß Figur 2,

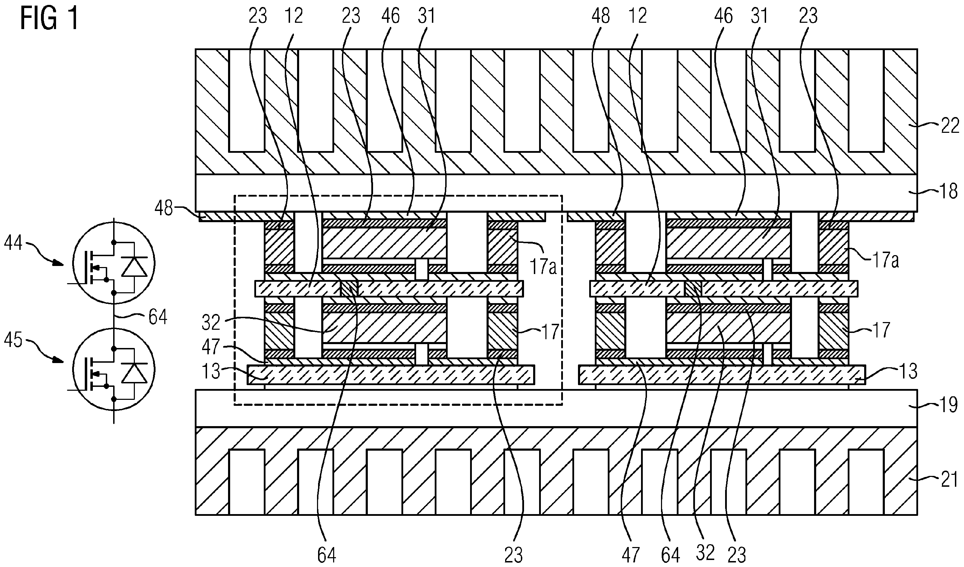

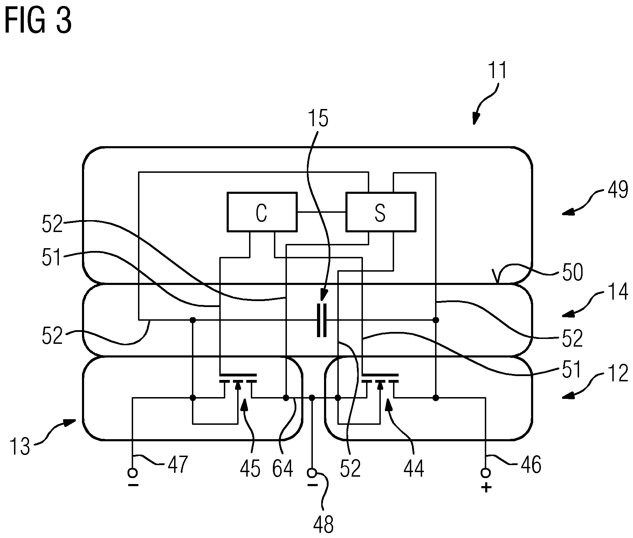

In Figur 1 ist ein Leistungsmodul 11 dargestellt (Systemgrenzen sind gestrichelt eingezeichnet), wobei auch dargestellt ist, wie mehrere Leistungsmodule zu einer leistungselektronischen Schaltung kombiniert werden können. Das Leistungsmodul 11 besteht aus einem ersten Bauelement 31 und einem zweiten Bauelement 32, welche jeweils als erster Transistor 44 und zweiter Transistor 45 ausgeführt sind. Diese können eine Schaltung mit einer Halbbrücke 64 ausbilden, wobei die Schaltung in Figur 1 angedeutet ist und zu Figur 3 im Folgenden noch näher erläutert wird.

Das erste Bauelement 31 und das zweite Bauelement 32 sind jeweils auf einer ersten Substratplatte 12 und einer zweiten Substratplatte 13 montiert. Hierbei kommen verschiedene Leiterbahnen auf der ersten Substratplatte 12 und der zweiten Substratplatte 13 zum Einsatz. Außerdem ist die zweite Substratplatte 13 auf einer zweiten Basisplatte 19 montiert, wobei auch hier eine elektrische Kontaktierung stattfinden kann, wie in Figur 1 angedeutet. Das erste Bauelement 31 ist über eine erste Basisplatte 18 ebenfalls elektrisch kontaktiert.

Um eine Schaltung zu realisieren sind außerdem Distanzstücke 17, 17a vorgesehen, welche eine elektrische Kontaktierung zwischen den einzelnen Platten, d. h. der ersten Substratplatte 12, der zweiten Substratplatte 13, der ersten Basisplatte 18 und der zweiten Basisplatte 19 ermöglichen. Hierdurch können Leiterbahnen, die auf diesen Platten vorgesehen sind, untereinander elektrisch kontaktiert werden. Die elektrische Kontaktierung erfolgt über Lötverbindungen 23, von denen Figur 1 exemplarisch nur einige mit Bezugszeichen versehen wurden.

Die verschiedenen Leiterbahnen bilden gemäß Figur 1 einen Pluspol 46, einen Minuspol 47 und einen Phasenkontakt 48 aus. Am Pluspol 46 und Minuspol 47 kann eine Gleichspannung anliegen. Über den Phasenkontakt 48 lässt sich dann eine Wechselspannung abgreifen. Das Leistungmodul 11 gemäß Figur 1 ist somit als Umrichter zu gebrauchen. Die Funktion dieses Umrichters wird zu Figur 3 noch näher erläutert.

In der ersten Substratplatte 12 ist die Halbbrücke 64 als Durchkontaktierung vorgesehen. Dies hat den Vorteil, dass das erste Bauelement 31 und das zweite Bauelement 32 auf sehr direktem Wege miteinander kontaktiert werden können, so dass kurze elektrische Wege realisiert werden. Der Abgriff des Phasenkontakts kann dann über eine Leiterbahn auf der ersten Substratplatte 12 erfolgen.

Auf der ersten Basisplatte 18 und der zweiten Basisplatte 19 sind außerdem Kühlstrukturen 21, 22 realisiert, die als Rippenkühler ausgebildet sind. Auf diesem Wege kann die Wärme, die in dem ersten elektronischen Bauelement 31 und zweiten elektronischen Bauelement 32 entsteht, jeweils über die beiden Substratplatten 12, 13 und Basisplatten 18, 19 abgeführt werden. Die kurzen Wege ermöglichen dabei eine effektive Kühlung.

In Figur 1 lässt sich außerdem gut erkennen, dass die kleinste vorzufertigende Einheit zur modularen Herstellung der Leistungsmodule jeweils der Verbund einer Substratplatte 12, 13 und eines Bauelements 31, 32 und evtl. noch den Distanzstücken 17, 17a ist. Ein solcher Chip-Keramik-Verbund (kurz CKV) lässt sich in großer Stückzahl herstellen. Die Substratplatte kann beispielsweise aus einer Keramik bestehen, welche mit einer Vielzahl von Bauelementen bestückt wird. Anschließend kann eine Vereinzelung der jeweiligen CKV beispielsweise durch Trennen der Substratplatte erfolgen.

Das Aufbaukonzept bietet nach der Montage die Möglichkeit, den relevanten Bauraum hermetisch zu verschließen (s. Figur 1, hier kann umlaufend eine Abdichtung erfolgen). Eine Abrichtung würde dann den Spalt zwischen den Basisplatten 18, 19 überbrücken, wodurch der Bauraum entstünde (nicht dargestellt). Dadurch können Vorteile für die Isolationsstrategie (insbesondere Vakuum und Gase) und den Einsatz in kritischen Umgebungsbedingungen (insbesondere bei Feuchte, Schadgas usw.) generiert werden. Das Aufbaukonzept bietet auch die Möglichkeit der Integration von Sensoren (nicht dargestellt) für z.B. Temperatur und Strom.

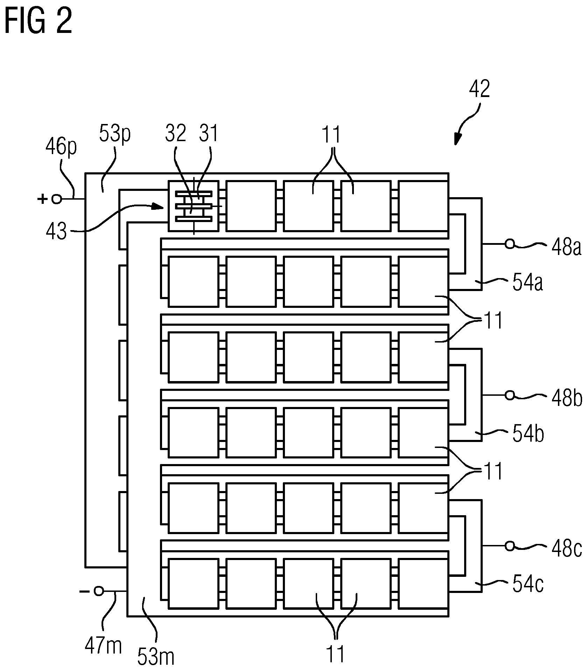

In Figur 2 ist dargestellt, wie mehrere Leistungsmodule 11 gemäß Figur 1 zu einer leistungselektronischen Schaltung 42 kombiniert werden können. Fünf Leistungsmodule 11 sind jeweils in einer Reihe 43 konfiguriert, wobei insgesamt sechs Reihen vorgesehen sind. Wie Figur 1 zu entnehmen ist, ergibt sich eine Kontaktierungsmöglichkeit für beide, also das erste Bauelement 31 und das zweite Bauelement 32, die in Figur 2 für jedes Leistungsmodul 11 realisiert ist und in Figur 3 schematisch als Schaltbild dargestellt ist.

In Figur 3 ist ein Kondensator 15 zur Komplettierung der Schaltung dargestellt. Dies dient der Vereinfachung der Darstellung, wobei alternativ auch eine Vielzahl parallel geschalteter Kondensatoren zum Einsatz kommen kann. Der Kondensator 15 gemäß Figur 3 ist lediglich schematisch dargestellt. Genauso verhält es sich mit der ersten Substratplatte 12 und der zweiten Substratplatte 13 sowie den auf diesen montierten leistungselektronischen Bauelementen, die durch einen ersten Transistor 44 und einen zweiten Transistor 45 ausgebildet sind. Der erste Transistor 44 ist mit seiner Source-Elektrode an den auch als High-Side bezeichneten Pluspol 46 angeschlossen, während der zweite Transistor 45 mit seiner Drain-Elektrode an den auch als Low-Side bezeichneten Minuspol 47 angeschlossen ist. Die Drain-Elektrode des ersten Transistors 44 ist mit der Source-Elektrode des zweiten Transistors 45 sind miteinander verbunden, wobei hierdurch eine Halbbrücke 64 mit einem Phasenkontakt 48 entsteht. Zur Ansteuerung des Leistungsmoduls 11 ist der Kondensator 15 mit einer Treiberschaltung 49 versehen.

Die Treiberschaltung 49 gemäß Figur 3 ist nur schematisch dargestellt, um deren Funktion im Grundsatz zu beschreiben. Die Treiberschaltung weist eine Controllerfunktion C auf sowie eine Sensorfunktion S. Die Controllerfunktion wird durch Kontaktleitungen 51 als Schnittstelle zu den Gate-Elektroden des ersten Transistors 44 und des zweiten Transistors 45 gewährleistet. Damit kann die Treiberschaltung beide Transistoren als Schalter intelligenter ansteuern. Die für diese Funktion notwendigen Informationen werden durch die Sensorfunktion S zur Verfügung gestellt. Die Sensorfunktion wird über Signalleitungen 52 gewährleistet, mit denen ein Stromfluss vor und hinter dem Kondensator 15 sowie vor und hinter dem Phasenkontakt 48 in der Halbbrücke 64 abgegriffen werden kann.

Der Kondensator 15 ist mit dem Pluspol 46 und dem Minuspol 47 verbunden und erfüllt damit eine Glättungsfunktion, die für einen mehrphasigen Betrieb der leistungselektronischen Schaltung 42 gemäß Figur 1 erforderlich ist.

Wie in Figur 2 zu erkennen ist, ist die leistungselektronische Schaltung 42 gemäß Figur 2 modular aufgebaut. Mittels der durch die Leistungsmodule 11 gemäß Figur 3 realisierten Schaltung können diese in drei Gruppen jeweils gemeinsam verwendet werden, um aus einer am gemeinsamen Pluspol 46p und am gemeinsamen Minuspol 47m anliegenden Gleichspannung eine dreiphasige Wechselspannung zu erzeugen, die an den gemeinsamen Phasenkontakten 48a, 48b, 48c abgegriffen werden kann. Die Höhe des zu schaltenden maximalen Stroms bestimmt, wie viele der Leistungsmodule 11 pro Phase zum Einsatz kommen müssen. Gemäß Figur 2 handelt es sich um jeweils zehn Leistungsmodule 11 pro Phase. Damit ist für jedes der Leistungsmodule 11 eine Schaltung gemäß Figur 4 realisiert, wobei jede Gruppe von Leistungsmodulen 11 parallel geschaltet ist.

### Bezugszeichenliste

- 11: Leistungsmodul
- 12: erste Substratplatte
- 13: zweite Substratplatte
- 15: Kondensator
- 16: Durchkontaktierung
- 17: Distanzstück
- 18: erste Basisplatte
- 19: zweite Basisplatte
- 20: Kontaktstruktur
- 21: Kühlstruktur
- 22: Kühlstruktur
- 23: Lötverbindung
- 31: erstes Bauelement
- 32: zweites Bauelement
- 42: leistungselektronische Schaltung
- 44: erster Transistor
- 45: zweiter Transistor
- 46: Pluspol
- 47: Minuspol
- 48: Phasenkontakt
- 49: Treiberschaltung
- 51: Kontaktleitung
- 52: Signalleitung
- 64: Halbbrücke

## Patentansprüche

1. Leistungsmodul (11) mit einem leistungselektronischen ersten Bauelement (31), welches auf einer ersten Substratplatte (12) angeordnet ist,
**dadurch gekennzeichnet,**
**dass** ein leistungselektronisches zweites Bauelement (32), welches auf einer zweiten Substratplatte (13) montiert ist, vorgesehen ist, wobei die erste Substratplatte (12), das erste Bauelement (31), die zweite Substartplatte (13) und das zweite Bauelement (32) einen Stapel bilden.

2. Leistungsmodul (11) nach Anspruch 1,
**dadurch gekennzeichnet,**
**dass** eine Oberseite des zweiten Bauelements (32) elektrisch mit einer Unterseite der ersten Substratplatte (12) verbunden ist.

3. Leistungsmodul (11) nach Anspruch 2,
**dadurch gekennzeichnet,**
**dass** das zweite Bauelement (32) mit dem ersten Bauelement (31) über einen elektrischen Verbindungspfad kontaktiert ist.

4. Leistungsmodul (11) nach Anspruch 3,
**dadurch gekennzeichnet,**
**dass** der elektrische Verbindungspfad als Durchkontaktierung in der ersten Substratplatte (12), insbesondere als Via, ausgebildet ist.

5. Leistungsmodul (11) nach einem der Ansprüche 3 oder 4,
**dadurch gekennzeichnet,**
**dass** der elektrische Verbindungspfad als Halbbrücke (64) ausgeführt ist, die einen Phasenkontakt (48) zur Verfügung stellt.

6. Leistungsmodul (11) nach einem der voranstehenden Ansprüche,
**dadurch gekennzeichnet,**
**dass** zwischen der ersten Substratplatte (12) und der zweiten Substratplatte (13) mindestens ein Distanzstück (17) angeordnet ist, das die erste Substratplatte (12) und die zweite Substratplatte (13) miteinander verbindet.

7. Leistungsmodul (11) nach Anspruch 6,
**dadurch gekennzeichnet,**
**dass** das mindestens eine Distanzstück (17) elektrisch leitend ausgeführt ist und auf der ersten Substratplatte (12) und der zweiten Substratplatte (13) mit elektrischen Leiterbahnen verbunden ist.

8. Leistungsmodul (11) nach einem der voranstehenden Ansprüche,
**dadurch gekennzeichnet,**
**dass** die erste Substratplatte (12) mit einer zweiten Basisplatte (19) verbunden ist.

9. Leistungsmodul (11) nach einem der voranstehenden Ansprüche,
**dadurch gekennzeichnet,**
**dass** das erste Bauelement (31) auf einer Oberseite mit einer ersten Basisplatte (18) verbunden ist.

10. Leistungsmodul (11) nach Anspruch 9,
**dadurch gekennzeichnet,**
**dass** zwischen der ersten Substratplatte (12) und der ersten Basisplatte (18) mindestens ein Distanzstück (17a) angeordnet ist, das die erste Substratplatte (12) und die erste Basisplatte (18) miteinander verbindet.

11. Leistungsmodul (11) nach Anspruch 10,
**dadurch gekennzeichnet,**
**dass** das mindestens eine Distanzstück (17a) elektrisch leitend ausgeführt ist und auf der ersten Substratplatte (13) und der ersten Basisplatte (18) mit elektrischen Leiterbahnen verbunden ist.

12. Leistungsmodul (11) nach einem der Ansprüche 8 bis 11,
**dadurch gekennzeichnet,**
**dass** die erste Basisplatte (18) und/oder die zweite Basisplatte (19) eine Kühlstruktur (21, 22) aufweist/aufweisen.

13. Leistungselektronische Schaltung mit einer Vielzahl von Leistungsmodulen, insbesondere Umrichter,
**dadurch gekennzeichnet,**
**dass** die Leistungsmodule (11) nach einem der voranstehenden Ansprüche aufgebaut sind die Leistungsmodule (11) jeweils durch eine Basisplatte elektrisch verbunden sind.

14. Leistungselektronische Schaltung nach Anspruch 13,
**dadurch gekennzeichnet,**
**dass** die Leistungsmodule (11) je zwei als erstes Schaltelement und als zweites Schaltelement ausgebildete leistungselektronische Bauelemente (31) aufweisen, wobei
• das erste Schaltelement und das zweite Schaltelement zu einem gemeinsam Leistungsanschluss, insbesondere einem Phasenkontakt (48), zusammengeschlossen sind,
• das erste Schaltelement einen als Pluspol (46) ausgeführten ersten Leistungsanschluss und das zweite Schaltelement einen als Minuspol (47) ausgeführten zweiten Leistungsanschluss aufweisen.

15. Leistungselektronische Schaltung (42) nach Anspruch 14,
**dadurch gekennzeichnet,**
**dass** die Leistungsmodule (11) in drei Gruppen mit jeweils gleich vielen Leistungsmodulen (11) unterteilt sind, wobei
• die ersten Leistungsanschlüsse aller Schaltelemente elektrisch miteinander verbunden sind und einen gemeinsamen Minuspol (47m) bilden,
• die zweiten Leistungsanschlüsse aller Schaltelemente elektrisch miteinander verbunden sind und einen gemeinsamen Pluspol (46p),
• in jeder der drei Gruppen die gemeinsamen Leistungsanschlüsse elektrisch miteinander verbunden sind und drei gemeinsame Leistungsanschlüsse mit je einem gemeinsamen Phasenkontakt (48a, 48b, 48c) ausbilden.
